Europäisches Patentamt

European Patent Office

Office européen des brevets

(11) Veröffentlichungsnummer: **0 335 281**

**A2**

(12) # EUROPÄISCHE PATENTANMELDUNG

(21) Anmeldenummer: **89105322.5**

(22) Anmeldetag: **24.03.89**

(51) Int. Cl.4: **H05K 3/46 , H01L 23/52**

(30) Priorität: **28.03.88 DE 3810486**

(43) Veröffentlichungstag der Anmeldung:
**04.10.89 Patentblatt 89/40**

(84) Benannte Vertragsstaaten:
**AT BE CH DE ES FR GB GR IT LI LU NL SE**

(71) Anmelder: **KALETO AG**
**Kolinplatz 9**
**CH-6301 Zug(CH)**

(72) Erfinder: **Simone, Antonio, Dr.**
**c/o Xerés Treuhand AG**
**Kolinplatz 9 CH-6301 Zug(CH)**

(74) Vertreter: **Hafner, Dieter, Dr.rer.nat.,**
**Dipl.-Phys.**
**Ostendstrasse 132**
**D-8500 Nürnberg 30(DE)**

(54) **Verfahren zum Herstellen kundenspezifischer gedruckter Schaltungen.**

(57) Die vorliegende Erfindung betrifft ein Verfahren zum Herstellen kundenspezifischer gedruckter Schaltungen sowie eine durch dieses Verfahren hergestellte elektrische Schaltung. Für kundenspezifische Schaltungen sind bisher zeitaufwendige und kostenspielige Entwicklungen erforderlich gewesen. Das neue Verfahren soll die Herstellung insbesondere von kundenspezifischen Leiterplatten mit geringem Aufwand und mit kurzen Entwicklungszeiten gewährleisten. Dieses Problem wird durch ein Verfahren gelöst, welches folgende Verfahrensmerkmale aufweist:

Vorsehen von mindestens zwei unabhängig von den Kundenwünschen immer verwendbaren Standardleiterbahnebenenauslegungen 1, 2, von denen die eine Leiterbahnebenenauslegung 1 in vorgegebener Anordnung eine Anzahl von sich nicht kreuzenden Leiterbahnen 3 und die andere Leiterbahnebenenauslegung 2 in vorgegebener Anordnung eine weitere Anzahl von sich nicht kreuzenden Leiterbahnen 4 enthält, die zumindest teilweise überlappend zu den Leiterbahnen 3 auf der einen Leiterbahnebene verlaufend angeordnet werden;

Aufbringen von mindestens einer individuellen, d. h. dem jeweiligen Kundenwunsch entsprechenden Isolationsschicht 5 mit Kontaktfenstern 8 für eine Zwei- oder Mehrebenen-Verdrahtung zur Verbindung der für die Schaltung vorgesehenen Komponenten, wobei die Kontaktfenster 8 an Stellen 9 der Leiterbahnkreuzungen und/oder Leiterbahnüberlappungen zwischen den Leiterbahnen 3, 4 der Standardleiterbahnebenenauslegungen 1, 2 vorgesehen werden;

Aufbringen mindestens der weiteren Standardleiterbahnebenenauslegung 2 durch Siebdruck; und gegebenenfalls Aufbringen weiterer Isolationsschichten 5 mit Kontaktfenstern sowie weiteren Standardleiterbahnebenen.

*Fig. 1*

Die vorliegende Erfindung betrifft ein Verfahren zum Herstellen kundenspezifischer gedruckter Schaltungen mit Mehrebenenverdrahtung, d. h. Durchkontaktierung zwischen mindestens zwei unabhängig von den Kundenwünschen immer verwendbaren Standardleiterbahnebenenauslegungen.

Auf dem Gebiet der Leiterbahntechnologie ist es bekannt, flächenhafte Verdrahtungsstrukturen in Form dünner Metallschichten in einer oder mehreren Lagen auf Isolierstoffplatten aufzubringen, derart, daß diese Verdrahtungsstrukturen die elektrischen Verbindungen der Schaltungkomponenten untereinander bilden. Ferner ist es in der sogenannten Multilayer-Technik bekannt, Leiterplatten mit mehreren Leiterbahnebenen zu verwenden, deren Leiterzüge über metallisierte Löcher leitend verbunden sind, d. h. also eine Durchkontaktierung vorgesehen ist, wobei z. B. chemisch-galvanisch durchkontaktierte Löcher zwischen den einzelnen Leiterschichten vorgesehen werden. Die aus den Leiterbahnen bestehenden Verdrahtungsmuster selbst werden gemäß dem Stand der Technik entweder durch Ätzen einer kupferkaschierten Platte, durch Siebdruck oder durch galvanisches Aufbringen von Kupfer erzeugt.

Darüber hinaus ist es auf dem Gebiet der integrierten Schaltungen bekannt, für spezielle Anwendungsgebiete kundenspezifische IC's zu entwickeln. Derartige Entwicklungen sind jedoch sehr zeitaufwendig und erfordern in der Regel einen Zeitraum von ein bis zwei Jahren als Entwicklungs- und Testzeit, wodurch Kosten in der Größenordnung von meistens mehre ren DM 100.000,00 anfallen. Infolgedessen sind derartige Spezialentwicklungen von IC's lediglich dann lohnend, wenn es sich um große Stückzahlen handelt.

Bekannt sind weiterhin sog. "Uncommited Logic Arrays" (ULA) oder "Gate-Arrays", bei welchen es sich um integrierte Schaltungen mit einer Anordnung gleicher Grundzellen handelt, so daß durch spezielles Legen und Einprogrammieren von Leiterbahnen kundenspezifische Schaltungen beliebig definierbar und herstellbar sind, wodurchanwendungsorientiert ganz bestimmte integrierte Schaltungen herstellbar und infolgedessen spezielle Schaltungsaufgaben lösbar sind. Allerdings sind auch hier die vorzunehmenden Entwicklungen noch relativ zeit- und kostenaufwendig, so daß vom Kunden auch hier mindestens 10.000 - 20.000 Stück derartiger IC's abgenommen werden müssen, damit überhaupt kostendeckend gearbeitet werden kann.

Ein Ziel der vorliegenden Erfindung ist es daher, ein Verfahren zum Herstellen kundenspezifischer gedruckter Schaltungen zu schaffen, welches die Möglichkeit bietet, dreidimensionale Schaltungen unter Verwendung von standardisierten Leiterbahnebenen nach individuellen kundenspezifischen Vorstellungen in einfacher und kostengünstiger Weise herzustellen.

Dieses Ziel wird durch die im Anspruch 1 aufgezeigte technische Lehre gelöst. Das erfindungsgemäße Verfahren hat den Vorteil, daß die Realisierung kundenspezifischer gedruckter Schaltungen mit geringem Aufwand sowie mit kurzen Entwicklungszeiten gewährleistet werden kann. Hierdurch wird eine Fertigung von anwendungsorientierten, individuell ausgestalteten Schaltungen auch in kleinen Stückzahlen rentabel.

Eine besonders einfach auszuführende Ausgestaltung des erfindungsgemäßen Verfahrens ist dadurch gekennzeichnet, daß die Isolationsschicht durch Siebdruck auf die erste Leiterbahnebene aufgetragen wird.

Eine in eine andere Richtung gehende Ausgestaltung des erfindungsgemäßen Verfahrens ist dadurch gekennzeichnet, daß die Isolationsschicht als Klebefolienschicht ausgebildet ist. Auch hierdurch läßt sich die Isolationsschicht in überraschend einfacher Weise realisieren. Beide vorstehenden Ausgestaltungen des erfindungsgemäßen Verfahrens sind zudem in einfacher Weise einer Automatisierung zugänglich. Das Aufbringen der Isolationsschicht in Form einer Klebefolienschicht ist darüber hinaus apparativ relativ einfach zu verwirklichen.

Die Ausgestaltung des erfindungsgemäßen Verfahrens nach Anspruch 4 hat den Vorteil, daß man gleichsam neben den Standardleiterbahnebenen eine standardisierte, d. h. mit einem einheitlichen Muster von Kontaktfenstern versehene Isolationsschicht aufbringt, und diese Isolationsschicht nachträglich durch gezieltes Verschließen einzelner Kontaktfenster den jeweiligen Anforderungen, die vom Benutzer gestellt werden, anpassen kann. Hierdurch wird die Flexibilität des Verfahrens noch gesteigert.

Dadurch, daß gemäß einer weiteren zweckmäßigen Ausgestaltung des erfindungsgemäßen Verfahrens das für den Siebdruck verwendete Sieb vor dem Siebdruckvorgang an Stellen der vorgesehenen Kontaktfenster verschlossen wird, wodurch beim Siebdruck Schicht-Öffnungen zur Bildung der Kontaktfenster erzielt werden, kann in einfacher Weise maschinell das gewünschte Öffnungsmuster der Kontaktfenster realisiert werden.

Um ein gezieltes Verschließen bestimmter Kontaktfenster in der Isolationsschicht in einfacher Weise durchzuführen, können gemäß einer weiteren Ausgestaltung des erfindungsgemäßen Verfahrens offene Kontaktfenster in der aufgetragenen Isolationsschicht durch einen Dispenser verschlossen werden, welcher über die Isolationsschicht an die Kontaktfensterstellen geführt wird und mit welchem Isolationsschichtmaterial in die schließenden Kontaktfenster eingespritzt wird. Hierdurch läßt sich in einfacher Weise ein den Anforderungen des jeweiligen Kunden entsprechendes Kontaktfenstermuster anfertigen.

Eine in eine andere Richtung gehende Ausgestaltung des erfindungsgemäßen Verfahrens ist dadurch gekennzeichnet, daß die Kontaktfenster in der aufgetragenen Isolationsschicht gezielt beispielsweise durch Foto- und/oder Laser- und/oder Röntgenstrahl- und/oder Ionenstrahltechnik und/oder eine ähnliche Technik hergestellt werden. Auch diese Ausgestaltung bietet den Vorteil einer einfachen Automatisierbarkeit des Verfahrensschritts der Bildung der Kontaktfenster in der Isolationsschicht.

Eine weitere zweckmäßige Ausgestaltung des erfindungsgemäßen Verfahrens ist dadurch gekennzeichnet, daß die Dicke der durch Siebdruck aufgebrachten mindestens einen weiteren Standardleiterbahnebenenauslegung im Bereich der Kontaktfenster derart bemessen ist, daß das Leiterbahnmaterial die Kontaktfenster der darunterliegenden Isolationsschicht voll inhaltlich ausfüllt und damit die Leiterbahnebenen miteinander kontaktiert. Hierdurch läßt sich in einfacher Weise ein Aufbringen der betreffenden Leiterbahnebene bei gleichzeitiger Durchkontaktierung realisieren. Folglich sind gesonderte Durchkontaktierungsmaßnahmen hierbei vorteilhafterweise nicht notwendig.

Dadurch, daß die Kontaktfenster in der Isolationsschicht hinsichtlich ihrer Durchmesser - gemäß einer weiteren Ausgestaltung des erfindungsgemäßen Verfahrens - kleiner als die Breite der Leiterbahnen ausgebildet werden, wird der Vorteil geschaffen, daß man bei einer fertigen Leiterplatte anhand der Kontaktfenster-Isolationsschichten nicht erkennen kann, wo sich deren Kontaktfenster befinden, da diese so klein gehalten sind, daß sie durch die Leiterbahnen abgedeckt werden.

Weder durch röntgenoptische, lichtoptische oder ähnliche Mittel ist es möglich oder nur erschwert möglich, die fertige, kundenspezifische Schaltung im Nachhinein zu analysieren.

Die nach dem erfindungsgemäßen Verfahren hergestellte, kundenspezifische Schaltung gewährleistet daher für den Auftraggeber eine Art von Schaltungs-Nachahmungsschutz.

Eine weitere zweckmäßige Ausgestaltung des erfindungsgemäßen Verfahrens ist dadurch gekennzeichnet, daß je eine Vorlage zur Herstellung der individuellen Kontaktfenster-Isolationsschicht(en) mittels CAD-Technik oder -Programmierung hergestellt wird. Hierbei besteht der Vorteil, daß eine kundenspezifische Variation pro Leiterplatte dadurch erfolgen kann, daß kundenspezifisch durch ein CAD-System gleichsam ein Bild der individuellen Kontaktfenster-Isolierschicht erstellt wird, so daß bei vorgegebenen Standard-Leiterbahnebenen mit entsprechend definierten Leiterbahnrastern lediglich noch definiert werden muß, welche Leiterbahnkreuzungs- und/oder -überlappungsstellen offenzubleiben haben bzw. geschlossen werden müssen.

Beispielsweise kann mittels eines Computers bzw. eines kundenspezifisch einsetzbaren Programms über einen Plotter das Layout erstellt werden, anhand dessen sodann eine Siebdruckmaske als eine individuelle Kontaktfenster-Isolationsschicht vorbereitet wird. In gleicher Weise kann das Computerbild natürlich auch unmittelbar mit einer der in Unteranspruch 7 dargelegten Techniken kombiniert werden, wodurch die Möglichkeit geschaffen wird, über den Computer unter Zuhilfenahme der besagten Techniken direkt auf die Isolationsschicht einzuwirken.

Eine weitere zweckmäßige Ausgestaltung des erfindungsgemäßen Verfahrens ist dadurch gekennzeichnet, daß vorzugsweise die oberste Standard-Leiterbahnebene der Schaltung an einer oder mehreren vorbestimmten Flächenbereichen mit einer oder mehreren vorgegebenen, kompletten, insbesondere integrierten Schaltungen (IC's) bestückt wird, die vorzugsweise nach Art der Hybridtechnik miteinander verbunden werden. Hierdurch wird beispielsweise die Möglichkeit eröffnet, zwei oder drei konventionelle IC's miteinander zu verbinden, die komplette Schaltung sodann zu vergießen und gleichsam als Hybridschaltung dem Anwender anzubieten.

Weitere zweckmäßige Verfahrensvarianten ergeben sich aus den Ansprüchen 12 und 13.

Eine weitere zweckmäßige Ausgestaltung des erfindungsgemäßen Verfahrens besteht darin, daß eine Vorlage zum Bestücken der Leiterplatte oder ein Programm mittels CAD-Technik erstellt wird. Hierdurch besteht die Möglichkeit, das Bestücken der am obersten befindlichen Standard-Leiterbahnauslegung mit den für die Schaltung vorgesehenen Komponenten, Zellen, Baugruppen, IC's o. dgl. mittels CAD-Technik oder mit Hilfe eines Bestükkungsautomaten durchzuführen. Hierbei muß beispielsweise das Programm eines derartigen Bestückungsautomaten nicht kundenspezifisch festgelegt werden, vielmehr genügt es, wenn der Automat weiß, daß eine ganz bestimmte Schaltungskomponente oder ein Bauelement o. dgl. an einer vorbestimmten Stelle der Standard-Leiterbahnauslegung plaziert werden muß.

Zweckmäßigerweise ist als isolierender Träger für die Leiterplatte ein übliches Leiterplattenmaterial, wie zum Beispiel Hartpapier oder Kunststoff zu verwenden. Bei materialspezifischen Spezialanforderungen ist zweckmäßigerweise auch als isolierender Träger eine Glas- oder Keramikplatte verwendbar.

Zweckmäßigerweise werden die einzelnen Standard-Leiterbahnauslegungen wie die dazwischenliegende, individuelle Kontaktfenster-Isolationsschicht mittels Siebdrucktechnik auf mindestens eine Oberfläche des Trägers nacheinander aufgebracht.

Die fertige, nach dem erfindungsgemäßen Verfahren hergestellte Schaltung oder Leiterplatte wird zweckmäßigerweise mit einer oder mehreren Vergußmassen vergossen.

Gemäß einer weiteren Ausgestaltung des erfindungsgemäßen Verfahrens wird das Verfahren unter Verwendung der SMD(Surface Mounted Devices)-Technik durchgeführt. Eine weitere zweckmäßige Ausgestaltung des erfindungsgemäßen Verfahrens ist in Unteranspruch 21 beschrieben.

Gemäß Unteranspruch 22 umfaßt die vorliegende Erfindung nicht nur das erfindungsgemäße Verfahren, sondern auch eine elektrische Schaltung, die gemäß dem Verfahren nach einem der Ansprüche 1 - 21 hergestellt ist.

Zweckmäßigerweise ist die Funktion der elektrischen Schaltung bzw. einer kundenspezifischen Leiterplatte durch die Auswahl der Schaltungskomponenten, Zellen, Baugruppen, IC's, Hybride o. dgl. individuell bestimmbar.

Zur näheren Erläuterung der Erfindung, ihrer weiteren Merkmale und Vorteile dient die beigefügte Zeichnung, in welcher Ausführungsbeispiele von nach dem erfindungsgemäßen Verfahren hergestellten Leiterplatten dargestellt sind. Gleiche Teile und Elemente sind hierbei stets mit den gleichen Bezugsziffern bezeichnet.

Dabei zeigt:

Fig. 1 schematisch eine aus zwei Standard-Leiterbahnebenen, einer Kontaktfenster-Isolationsschicht sowie einem isolierenden Träger bestehende Anordnung in einem noch nicht aufeinandergeschichteten Zustand;

Fig. 2 eine schematische Draufsicht auf eine fertige Leiterplatte, bei der die elektrischen Verbindungen der Schaltungskomponenten bzw. Baugruppen u. dgl. untereinander noch nicht vorgenommen sind;

Fig. 3 eine der Fig. 2 entsprechende Ansicht einer Leiterplatte, die mit zwei integrierten Schaltkreisen bestückt ist, wobei nunmehr die elektrischen Verbindungen der Schaltungskomponenten untereinander mittels Zweiebenenverdrahtungen bereits durchgeführt sind; und

Fig. 4 ein Blockschaltbild eines programmierbaren Frequenzteilers mit den beiden integrierten Schaltkreisen, die auf der Leiterplatte gemäß Fig. 3 angeordnet sind.

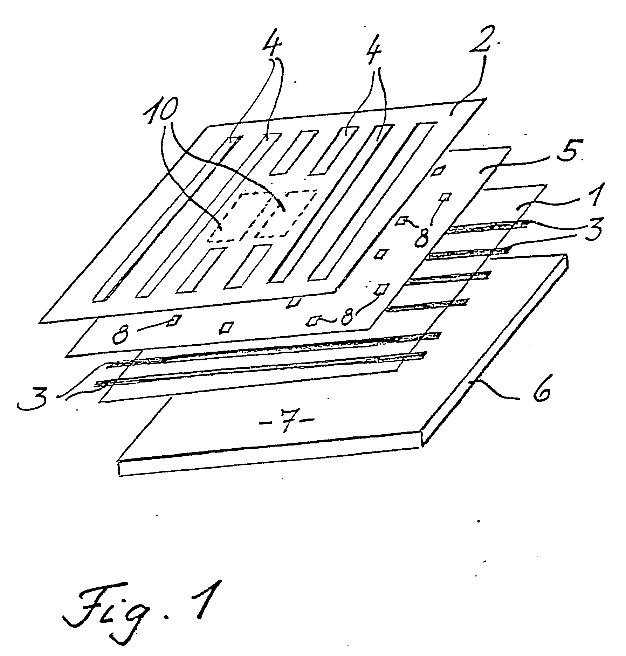

Wie aus Fig. 1 zu ersehen ist, besteht eine nach dem erfindungsgemäßen Verfahren hergestellte Mehrlagen-Leiterplatte beispielsweise aus zwei Standardleiterbahnebenenauslegungen bzw. Standard-Leiterbahnebenen 1 und 2, einer Isolationsschicht bzw. Kontaktfenster-Isolationsschicht 5 sowie einem isolierenden Träger 6. Die eine Leiterbahnebene 1 weist in vorgegebener Anordnung eine Anzahl von sich nicht kreuzenden, im wesentlichen zueinander parallel verlaufenden Leiterbahnen 3 auf, während die andere Leiterbahnebene 2 mit einer weiteren Anzahl von sich ebenfalls nicht kreuzenden, im wesentlich zueinander parallel verlaufenden Leiterbahnen 4 in vorgegebener Anordnung versehen ist, derart, daß diese Leiterbahnen 4 der Leiterbahnebene 2 im wesentlichen rechtwinklig oder zumindest annähernd rechtwinklig zu der Ausrichtung der Leiterbahnen 3 auf der Leiterbahnebene 1 verlaufen. Die Ausrichtung der Leiterbahnen kann aber auch anders sein, wie z. B. über- oder nebeneinander verlaufend im Verhältnis der Leiterbahnebenen zueinander.

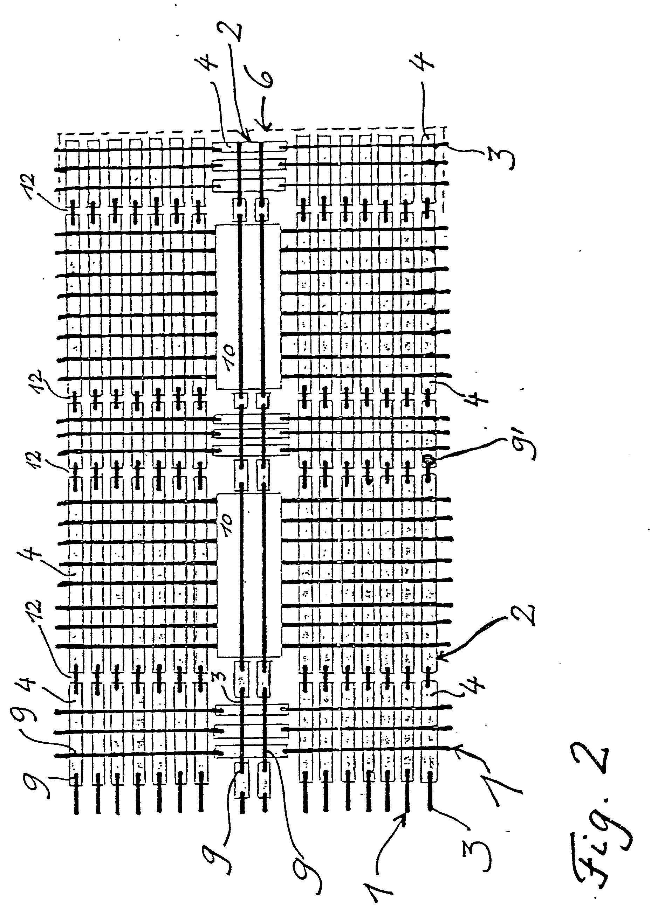

Die zwischen den beiden Standard-Leiterbahnebenen 1 und 2 angeordnete, individuelle Kontaktfenster-Isolationsschicht 5 ist mit Kontaktfenstern 8 an Stellen 9 (vgl. Fig. 2) der Leiterbahnkreuzungen und der Leiterbahnüberlappungen zwischen den jeweiligen Leiterbahnen 3 und 4 versehene so daß durch diese Kontaktfenster 8 hindurch eine Zweiebenenverdrahtung zum Zwecke der Verbindung der für die Schaltung vorgesehenen Komponenten, Zellen, Baugruppen, IC's oder dergleichen vorgenommen werden kann.

Diese Stellen 9 der Leiterbahnkreuzungen und Leiterbahnüberlappungen werden nach Maßgabe der jeweils gewünschten kundenspezifischen Schaltungsfunktion gewählt, wobei dann die hierzu erforderliche, individuelle Kontaktfenster-Isolationsschicht 5 beispielsweise mittels CAD-Technik hergestellt wird.

Die Fig. 1 zeigt schematisch die Reihenfolge der Aufeinanderschichtung der Standard-Leiterbahnebenen 1 und 2 und der Kontaktfenster-Isolationsschicht 5 auf einer Oberfläche 7 des isolierenden Trägers 6, wobei die Leiterbahnebene 1 die untere, unmittelbar auf die Oberfläche 7 gelangende Ebene darstellt, die Kontaktfenster-Isolationsschicht 5 die darauffolgende Ebene und die Leiterbahnebene 2 letztendlich die obere Ebene bildet, welche mit den für die Schaltung vorgesehenen Komponenten, Zellen, Baugruppen oder dergleichen bestückt wird.

Zu diesem Zweck weist die Leiterbahnebene 2 zwischen ihren Leiterbahnen 4 Flächenbereiche 10 für eine Plazierung der Schaltungskomponenten und dergleichen mehr auf.

Um zu verhindern, daß die Stellen der Durchkontaktierungen 9' (vgl. Fig. 2) an den Leiterbahnkreuzungs- und -überlappungsstellen von außen ersichtlich sind, weisen die Kontaktfenster 8 in der Kontaktfenster-Isolationsschicht 5 Durchmesser auf, die stets kleiner sind als die Breite der Leiterbahnen 4 in der Leiterbahnebene 2.

In der Fig. 2 ist eine Draufsicht auf eine fertige Leiterplatte mit zwei Standard-Leiterbahnebenen 1 und 2 dargestellt, von denen die eine Ebene vorbestimmte Flächenbereiche 10 aufweist, welche zur Bestückung der Leiterplatte mit vorgegebenen integrierten Schaltungen 11 dient, wie dies im einzelnen näher aus der Fig. 3 zu ersehen ist.

Wie die Fig. 2 und 3 ferner zeigen, weisen beispielsweise die Leiterbahnen 4 der Standard-Leiterbahnebenen 2 an vorgegebenen Stellen Unterbrechungen 12 auf, um die Leiterbahnlänge (Kopplung) kurz zu halten. Die diese Unterbrechungen 12 überbrückenden Kopplungen dienen zusätzlich zur Erhöhung der Flexibilität der Benutzung der Leiterbahnen 1 und 2 bei der Herstellung der Leiterplatte.

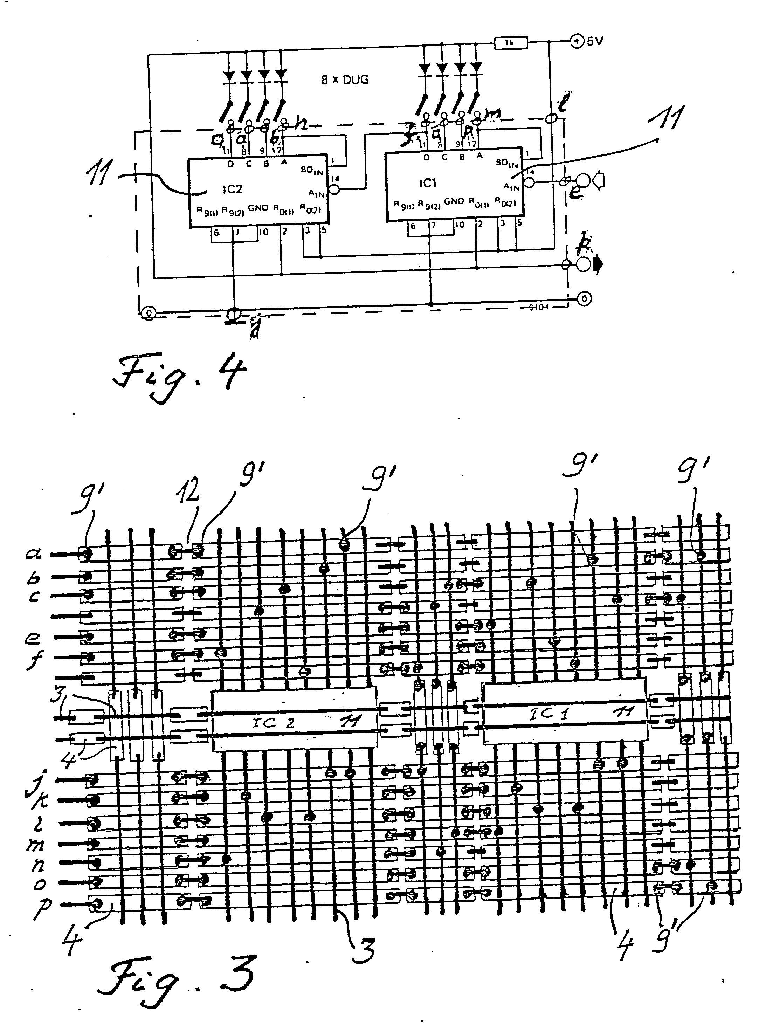

Bei den integrierten Schaltungen 11, mit denen die Leiterplatte gemäß Fig. 3 bestückt ist, handelt es sich beispielsweise um integrierte Schaltungen IC1 und IC2 für einen kundenspezifisch konzipierten, programmierbaren Frequenzteiler, dessen Blockschaltbild in der Fig. 4 dargestellt ist, auf dessen nähere Beschreibung jedoch verzichtet werden soll.

Die Stellen 9 der Leiterbahnkreuzungen und Leiterbahnüberlappungen zwischen den jeweiligen Leiterbahnen 3 und 4 der beiden Standard-Leiterbahnebenen 1 und 2 und damit die entsprechenden Stellen der Durchkontaktierungen 9' durch die Kontaktfenster 8 der Kontaktfenster-Isolationsschicht 5 (vgl. Fig. 1) stellen diejenigen Stellen dar, an denen die elektrischen Verbindungen zwischen den integrierten Schaltkreisen IC1 und IC2 sowie weiteren Schaltungskomponenten und dergleichen mehr erfolgen sollen.

Diese elektrischen Anschluß- oder Verbindungsstellen sind in den Fig. 3 und 4 mit a, b, c, e, f, j, k, 1, m, n, o und p bezeichnet.


**Ansprüche**

1. Verfahren zum Herstellen kundenspezifischer gedruckter Schaltungen mittels

I. Vorsehen von mindestens zwei unabhängig von den Kundenwünschen immer verwendbaren Standardleiterbahnebenenauslegungen (1, 2), von denen die eine Leiterbahnebenenauslegung (1) in vorgegebener Anordnung eine Anzahl von sich nicht kreuzenden Leiterbahnen (3) und die andere Leiterbahnebenenauslegung (2) in vorgegebener Anordnung eine weitere Anzahl von sich nicht kreuzenden Leiterbahnen (4) enthält, die zumindest teilweise überlappend zu den Leiterbahnen (3) auf der einen Leiterbahnebene verlaufend angeordnet werden;

II. Aufbringen von mindestens einer individuellen, d. h. dem jeweiligen Kundenwunsch entsprechenden Isolationsschicht (5) mit Kontaktfenstern (8) für eine Zwei- oder mehr Ebenen-Verdrahtung zur Verbindung der für die Schaltung vorgesehenen Komponenten, wobei die Kontaktfenster (8) an Stellen (9) der Leiterbahnkreuzungen und/oder Leiterbahnüberlappungen zwischen den Leiterbahnen (3, 4) der Standardleiterbahnebenenauslegungen (1, 2) vorgesehen werden;

III. Aufbringen mindestens der weiteren Standardleiterbahnebenenauslegung (2) durch Siebdruck;

IV. ggf. Aufbringen weiterer Isolationsschichten (5') mit Kontaktfenstern sowie weiterer Standardleiterbahnebenen.

2. Verfahren nach Anspruch 1,
dadurch gekennzeichnet,
daß die Isolationsschicht (5) durch Siebdruck auf die erste Leiterbahnebene aufgetragen wird.

3. Verfahren nach Anspruch 1,
dadurch gekennzeichnet,
daß die Isolationsschicht (5) als Klebefolienschicht ausgebildet ist.

4. Verfahren nach einem der Ansprüche 2 oder 3,
dadurch gekennzeichnet,
daß die Isolationsschicht nach dem Auftrag auf die erste Standardleiterbahnebenenauslegung an allen Stellen (9) der Leiterbahnkreuzungen und/oder Leiterbahnüberlappungen zwischen den Leiterbahnen (3 und 4) der beiden Standardleiterbahnebenenauslegungen mit Kontaktfenster (8) versehen sind und die Kontaktfenster (8) in einem Verfahrenszwischenschritt gezielt verschlossen werden.

5. Verfahren nach Anspruch 2,
dadurch gekennzeichnet,
daß das für den Siebdruck verwendete Sieb vor dem Siebdruckvorgang an Stellen der vorgesehenen Kontaktfenster verschlossen wird, wodurch beim Siebdruck Schicht-Öffnungen zur Bildung der Kontaktfenster erzielt werden.

6. Verfahren nach einem der vorhergehenden Ansprüche,
dadurch gekennzeichnet,
daß offene Kontaktfenster in der aufgetragenen Isolationsschicht durch einen Dispenser verschlossen werden, der über die Isolationsschicht an die Kontaktfensterstellen geführt wird und mit welchem Isolationsschichtmaterial in die zu schließenden Kontaktfenster eingespritzt wird.

7. Verfahren nach einem der vorhergehenden Ansprüche,
dadurch gekennzeichnet,
daß die Kontaktfenster in der aufgetragenen Isolationsschicht gezielt beispielsweise durch Photo- und/oder Laser- und/oder Röntgenstrahl- und/oder Ionenstrahltechnik und/oder eine ähnliche Technik hergestellt werden.

8. Verfahren nach einem der vorhergehenden Ansprüche,
dadurch gekennzeichnet,
daß die Dicke der durch Siebdruck aufgebrachten mindestens einen weiteren Standardleiterbahnebenenauslegung (2) im Bereich der Kontaktfenster (8) derart bemessen ist, daß das Leiterbahnmaterial die Kontaktfenster (8) der darunterliegenden Isolationsschicht voll inhaltlich ausfüllt und damit die Leiterbahnebenen (1, 2) miteinander kontaktiert.

9. Verfahren nach einem der vorhergehenden Ansprüche,
dadurch gekennzeichnet,
daß die Kontaktfenster (8) in der Isolationsschicht (5) hinsichtlich ihrer Durchmesser kleiner als die Breite der Leiterbahnen (1, 2) ausgebildet werden und damit die Stellen der Durchkontaktierungen zwischen den Leiterbahnebenen (1, 2) mit lichtoptischen oder röntgenoptischen oder dergleichen mitteln nicht oder nur erschwert eruierbar sind.

10. Verfahren nach einem der vorhergehenden Ansprüche,
dadurch gekennzeichnet,
daß je eine Vorlage zur Herstellung der individuellen Kontaktfenster-Isolationsschicht(en) (5) mittels CAD-Technik oder Programmierung hergestellt wird.

11. Verfahren nach einem der vorhergehenden Ansprüche,
dadurch gekennzeichnet,
daß vorzugsweise die oberste Standard-Leiterbahnebene (2) der Schaltung an einer oder mehreren vorbestimmten Flächenbereichen (10) mit einer oder mehreren vorgegebenen, kompletten, insbesondere integrierten Schaltungen (IC's) (11) bestückt wird, die vorzugsweise nach Art der Hybridtechnik miteinander verbunden werden.

12. Verfahren nach Anspruch 11,
dadurch gekennzeichnet,
daß die IC's (11) selbst programmierbar sind.

13. Verfahren nach einem der vorhergehenden Ansprüche,
dadurch gekennzeichnet,
daß vorzugsweise die oberste Standard-Leiterbahnebene (2) der Schaltung an einer oder mehreren vorbestimmten Flächenbereichen (10) mit einer oder mehreren ungekapselten, integrierten Schaltungen in Form von Chips bestückt wird, die vorzugsweise direkt auf der betreffenden Leiterbahnebene (2) bebondet werden.

14. Verfahren nach einem der vorhergehenden Ansprüche,
dadurch gekennzeichnet,
daß eine Vorlage zum Bestücken der Leiterplatte oder ein Programm mittels CAD-Technik erstellt wird.

15. Verfahren nach einem der vorhergehenden Ansprüche,
dadurch gekennzeichnet,
daß das Bestücken der Leiterplatte durch einen Automaten erfolgt.

16. Verfahren nach einem der vorhergehenden Ansprüche,
dadurch gekennzeichnet,
daß als isolierender Träger (6) ein übliches Leiterplattenmaterial, wie zum Beispiel Hartpapier oder Kunststoff verwendet wird.

17. Verfahren nach einem der vorhergehenden Ansprüche,
dadurch gekennzeichnet,
daß als isolierender Träger (6) eine Glas- oder Keramikplatte verwendet wird

18. Verfahren nach einem der vorhergehenden Ansprüche,
dadurch gekennzeichnet,
daß die einzelnen Standard-Leiterbahnebenen (1, 2) sowie die dazwischenliegende individuelle Kontaktfenster-Isolationsschicht (5) mittels Siebdrucktechnik auf mindestens eine Oberfläche des Trägers (6) nacheinander aufgebracht werden.

19. Verfahren nach einem der vorhergehenden Ansprüche,
dadurch gekennzeichnet,
daß die fertige, aus Standard-Leiterbahnebenen (1, 2), Kontaktfenster-losliatonsschicht(en) (5), isolierendem Träger (6) sowie den Schaltungskomponenten, Zellen, Baugruppen, IC's, Hybridschaltungen oder dergleichen bestehende Schaltung oder Leiterplatte mit Vergußmasse(n) vergossen wird.

20. Verfahren nach einem der vorhergehenden Ansprüche,
dadurch gekennzeichnet,
daß es unter Verwendung von SMD(Surface mounted Devices)-Technik durchgeführt wird.

21. Verfahren nach einem der vorhergehenden Ansprüche,
dadurch gekennzeichnet,
daß zwei oder mehrere dieser Schaltungen oder Leiterplatten untereinander verbunden werden.

22. Elektrische Schaltung, insbesondere Mehrlagen-Leiterplatte mit Durchkontaktierungen zwischen mindestens zwei Leiterbahnebenen, die gemäß dem Verfahren nach einem der Ansprüche 1 - 21 hergestellt ist.

23. Kundenspezifische Leiterplatte nach Anspruch 22,
dadurch gekennzeichnet,
daß ihre Funktion durch die Auswahl der Schaltungskomponenten, Zellen, Baugruppen, IC's, Hybride oder dergleichen individuell bestimmbar ist.

Fig. 1

Fig. 2

Fig. 4

Fig. 3